# EUROPÄISCHE PATENTANMELDUNG

(11) **EP 2 073 259 A2**
(43) Veröffentlichungstag der Anmeldung: **24.06.2009**
(21) Anmeldenummer: 08105982.6
(22) Anmeldetag: 15.12.2008
(51) Int. Cl.: H01L 21/60

(54) **Schaltungsträger, Verfahren zur Herstellung eines Schaltungsträgers sowie Bondverfahren**

(30) Priorität: 21.12.2007 DE 102007061942
(71) Anmelder: Continental Automotive GmbH, 30165 Hannover (DE)
(72) Erfinder: Bernhardt, Andreas, 93173 Wenzenbach (DE); Schingale, Angelika, 93059 Regensburg (DE)

(57) **Zusammenfassung**

Die Erfindung betrifft den Bereich der Bondtechnologie, insbesondere einen Schaltungsträger (10), z. B. Leiterplatte, für wenigstens ein mittels Bonddrähten (18-1, 18-2) daran anzubindendes Bauelement (BE), umfassend eine Leiterbahnanordnung (14) mit freiliegenden metallischen Bondbereichen (14-1, 14-2) zur schaltungsträgerseitigen Kontaktierung der Bonddrähte (18-1, 18-2). In der Praxis entstehen oftmals unkontrollierbare, oberflächliche "Störschichten" (z. B. natürliche Oxide, Flussmittel etc.), welche die Zuverlässigkeit des Bondprozesses seitens des Schaltungsträgers (10) erheblich beeinträchtigen. Um die Bondtechnologie ohne großen Aufwand hinsichtlich der Zuverlässigkeit der Fügestelle zwischen Drahtmaterial und Bondbereich zu verbessern, werden beim erfindungsgemäßen Schaltungsträger (10) die Bondbereiche (14-1, 14-2) jeweils mit einer beim Bondprozess vom Drahtmaterial zu durchdringenden Passivierungsschicht (20) ausgebildet. Derart kontrolliert passivierte Bondbereichoberflächen können denselben Grad an Güte und Haltbarkeit wie teuer veredelte Bondoberflächen bieten.

## Beschreibung

Die vorliegende Erfindung betrifft den Bereich der Bondtechnologie und insbesondere einen Schaltungsträger nach dem Oberbegriff des Anspruchs 1, ein Verfahren zur Herstellung eines Schaltungsträgers nach dem Oberbegriff des Anspruchs 7 sowie ein Verfahren zum Anbinden wenigstens eines Bauelements nach dem Oberbegriff des Anspruchs 8.

Derartige Vorrichtungen und Verfahren sind aus dem Stand der Technik hinreichend bekannt.

Für die Bondtechnologie sind die Oberflächen der freiliegenden metallischen Bondbereiche, an denen schaltungsträgerseitige Drahtenden der Bonddrähte angefügt werden, von entscheidender Bedeutung. In der Praxis ist insbesondere die Güte und Haltbarkeit dieser Oberflächen ein wichtiges Merkmal. Ein stetes und kalkulierbares Verhalten der Bondbereiche im Fertigungsablauf ist unabdingbar.

In der Praxis entstehen jedoch oftmals unkontrollierbare, oberflächliche "Störschichten" (z. B. natürliche Oxide, Flussmittel etc.), welche die Zuverlässigkeit des Bondprozesses seitens des Schaltungsträgers erheblich beeinträchtigen.

Insbesondere ergibt sich das Problem, dass während eines Zeitraumes zwischen der Fertigstellung des Schaltungsträgers und dessen Bestückung mit dem Bauelement oftmals eine Oxidschicht mit schwer oder gar nicht vorhersehbaren Eigenschaften an der Oberfläche des metallischen Bondbereiches (z. B. aus Kupfer) entsteht.

Zur Lösung dieses Problems, d. h. zur Schaffung von gut definierten Oberflächen der metallischen Bondbereiche, kommen zwei Methoden in Betracht:

Eine Möglichkeit besteht darin, mehr oder weniger unmittelbar vor dem Bondprozess die betreffenden Oberflächen zu reinigen bzw. die erwähnten Störschichten zu entfernen. Dies ist jedoch relativ aufwendig.

Eine zweite Möglichkeit besteht darin, die betreffenden Oberflächen bereits bei der Fertigung des Schaltungsträgers aus besonders "edlen Metallen" wie insbesondere Gold herzustellen. Dies ist jedoch nicht nur fertigungstechnisch aufwendig, sondern auch besonders teuer.

Es ist eine Aufgabe der vorliegenden Erfindung, die bekannte Bondtechnologie und insbesondere die eingangs erwähnten Vorrichtungen und Verfahren ohne großen Aufwand hinsichtlich der Zuverlässigkeit der Fügestelle zwischen Drahtmaterial und Bondbereich zu verbessern.

Diese Aufgabe wird gemäß der Erfindung durch einen Schaltungsträger nach Anspruch 1, ein Verfahren zur Herstellung eines Schaltungsträgers nach Anspruch 7 bzw. ein Verfahren zum Anbinden eines Bauelements nach Anspruch 8 gelöst. Die abhängigen Ansprüche betreffen vorteilhafte Weiterbildungen der Erfindung.

Die Grundidee der Erfindung besteht darin, dass kontrolliert passivierte Bondbereichoberflächen denselben Grad an Güte und Haltbarkeit wie teuer veredelte Bondoberflächen bieten können.

Bei dem erfindungsgemäßen Schaltungsträger ist vorgesehen, dass die Bondbereiche jeweils mit einer beim Bondprozess vom Drahtmaterial zu durchdringenden Passivierungsschicht ausgebildet sind (Anspruch 1). Derartige Passivierungsschichten lassen sich in einfacher Weise z. B. bereits bei der Herstellung des Schaltungsträgers ausbilden (Anspruch 7) oder nachträglich, jedoch vor dem Bondprozess (Anspruch 8).

In jedem Fall können vorteilhaft Kosten bei der Materialbeschaffung gespart werden und schwierige Veredelungsprozesse am Schaltungsträger eliminiert werden.

In einer bevorzugten Ausführungsform ist die Passivierungsschicht für deren Durchdringung bei einem Ultraschallschweißen des Drahtmaterials geeignet ausgebildet. Das Ultraschallschweißen ist die gängigste Methode zur Anfügung des Drahtmaterials an den metallischen Bondbereich.

Was das Material und die Art und Weise der Ausbildung der Passivierungsschicht anbelangt, so gibt es hierfür vielfältige Möglichkeiten und es kann insbesondere vorteilhaft auf Passivierungsmaterialien und Passivierungsmethoden zurückgegriffen werden, wie sie an sich aus dem Bereich der Mikroelektronik oder dem Bereich der Leiterplattenherstellung bekannt sind.

In einer besonders einfachen Ausführungsform ist beispielsweise vorgesehen, dass die Passivierungsschicht von einer Oxidschicht gebildet ist. Überraschenderweise hat sich herausgestellt, dass mit einer solchen kontrolliert ausgebildeten Oxidschicht, insbesondere einer vergleichsweise dünnen und dichten Oxidschicht, das eingangs erläuterte Problem einer "unkontrollierten Oxidation" durch die umgebende Luft vermieden werden kann. Bei der Oxidschicht kann es sich um ein Oxid desjenigen Metalls bzw. derjenigen Metalllegierung handeln, aus welcher der betreffende Bondbereich hergestellt ist. Alternativ kann jedoch auch die Aufbringung eines andersartigen Metalloxids vorgesehen sein.

In einer Ausführungsform ist vorgesehen, dass die Passivierungsschicht, insbesondere z. B. Oxidschicht, bevorzugt vergleichsweise dünn, in einer Art und Weise ausgebildet wird, die als solche zur Ausbildung einer Zwischenschicht bei der Herstellung mehrlagiger Schaltungsträger bekannt ist.

Beispielsweise kann als Passivierungsschicht eine Braunoxidschicht ausgebildet werden, wie diese als solche z. B. zur Verbesserung der Haftfestigkeit eines sogenannten Prepregs bei der Herstellung einer mehrlagigen Leiterplatte bekannt ist (auch z. B. "MAC etch bond", "Multibond" oder dergleichen).

Ein anderes Beispiel ist die Ausbildung einer organischen Passivierungsschicht, wie sie als solche z. B. als Oxidationsschutz von Lötpads von Leiterplatten bekannt ist und in diesem Bereich üblicherweise als "OSP" (Organic Solderability Preservatives) bezeichnet wird.

Die Ausbildung der Passivierungsschicht kann z. B. in einem Tauchbad erfolgen.

Mit den vorstehend beschriebenen und anderen Methoden lassen sich in einfacher und kostengünstiger Weise gut definierte und besonders haltbare Bondbereichoberflächen erzielen, was die Zuverlässigkeit des Bondprozesses erheblich steigert. Gegebenenfalls kann das zum Bonden verwendete Drahtmaterial oder spezielle Parameter des Bondprozesses (z. B. Parameter eines Ultraschallschweißprozesses) der konkret gewählten Passivierungsschicht angepasst werden.

Die Erfindung besitzt einen großen Anwendungsbereich, insbesondere was die Gestaltung des Schaltungsträgers und der daran anzubindenden Bauelemente anbelangt.

Bei dem Schaltungsträger kann es sich insbesondere um einen plattenförmigen Schaltungsträger handeln, bei welchem an wenigstens einer Flachseite ein Bauelement in der beschriebenen Weise anzubinden ist. Darunter fallen alle gängigen Arten von Leiterplatten, insbesondere organische Leiterplatten, seien diese einlagig oder mehrlagig, d. h. mit einer oder mehreren Leiterbahnlagen ausgebildet.

Bei dem anzubindenden Bauelement kann es sich z. B. um ein elektrisches oder elektronisches Bauelement wie insbesondere z. B. ein ungehäustes Halbleiterbauelement ("bare die") handeln.

Was die Bonddrähte anbelangt, so können diese im einfachsten Fall aus hierfür gängigem Drahtmaterial vorgesehen sein und z. B. einen Drahtdurchmesser im Bereich von etwa 10 µm bis 100 µm aufweisen, beim "Dickdrahtbonden" auch bis etwa 500 µm.

Die Bonddrähte können z. B. aus Aluminium oder Gold (gegebenenfalls mit speziellen Legierungszusätzen) gefertigt sein. Bonddrähte aus Gold oder einer Goldlegierung finden vor allem in der mikroelektronischen Verbindungstechnik Verwendung (z. B. zur Verbindung eines Siliziumchips mit einem Schaltungsträger in Form eines so genannten "lead frame". In anderen Bereichen sind z. B. auch Bonddrähte aus Aluminium oder einer Aluminiumlegierung gebräuchlich.

Die metallischen Bondbereiche, welche z. B. eine Fläche im Bereich von etwa 10² µm² bis etwa 10⁵ µm² ausbilden können, sind gemäß der Erfindung mit einer oberflächlichen Passivierungsschicht ausgebildet. Die Dicke, bevorzugt einheitliche Dicke, der Passivierungsschicht kann in weiten Grenzen gewählt bzw. der betreffenden Bondtechnologie angepasst werden, wobei lediglich sicherzustellen ist, dass die Schicht beim Bondprozess vom Drahtmaterial durchdrungen werden kann. Im konkreten Anwendungsfall wird eine geeignete Dicke der Passivierungsschicht daher auch von den Bondprozessparametern bzw. dem Bonddrahtmaterial und der Bonddrahtgeometrie abhängen. Für viele Anwendungsfälle hat sich eine Dicke der Passivierungsschicht im Bereich von etwa 0,1 µm bis etwa 50 µm, insbesondere 0,1 µm bis 20 µm als vorteilhaft herausgestellt.

Die Erfindung wird nachfolgend anhand eines Ausführungsbeispiels mit Bezug auf die beigefügten Zeichnungen weiter beschrieben. Es stellen jeweils schematisch dar:
- Fig. 1: eine Anbindung eines elektronischen Bauelements an einem Schaltungsträger mittels Drahtbonden,
- Fig. 2: ein Detail eines in Fig. 1 dargestellten Bondbereiches, und
- Fig. 3: eine mehrlagige Leiterplatte.

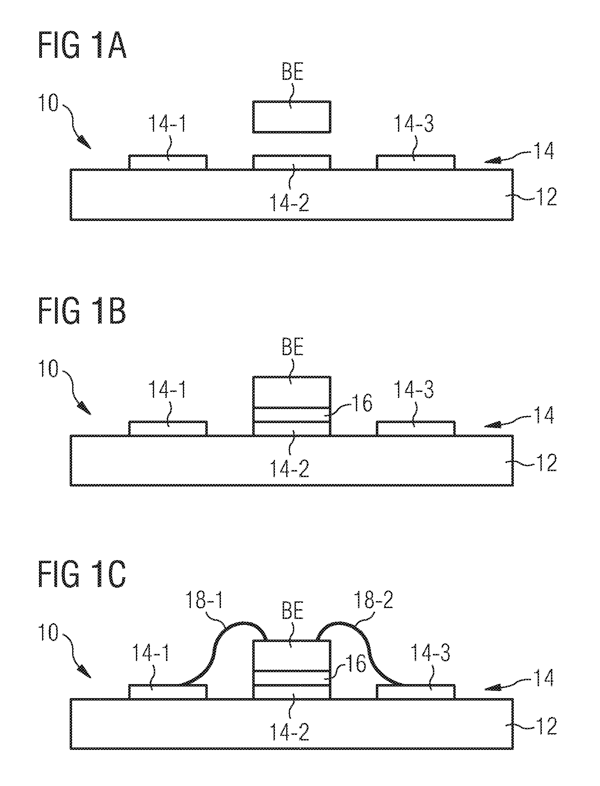

Fig. 1 zeigt mit Teildarstellungen gemäß Fig. 1A, 1B und 1C verschiedene Stadien der Anbindung eines Bauelements BE (z. B. ungehäustes Halbleiterbauelement) an einem Schaltungsträger 10 (z. B. Leiterplatte, "lead frame" etc.) umfassend ein Schaltungsträgersubstrat 12.

In Fig. 1A erkennt man das von dem Schaltungsträger 10 noch separate Bauelement BE unmittelbar vor dem Aufsetzen an einer (in Fig. 1 oberen) Flachseite, die in an sich bekannter Weise von einer strukturierten Leiterbahnanordnung 14 gebildet wird. In der schematischen Darstellung sind verschiedene Leiterbahnabschnitte des in diesem Ausführungsbeispiel einlagigen Schaltungsträgers mit 14-1, 14-2 und 14-3 bezeichnet.

Fig. 1B veranschaulicht den Zustand, nachdem das Bauelement BE unter Zwischenfügung einer wärmeleitenden Haftschicht 16 auf den Leiterbahnabschnitt 14-2 aufgesetzt wurde.

Fig. 1C veranschaulicht schließlich den Zustand, nachdem das aufgesetzte Bauelement BE mittels Bonddrähten, in der Figur mit 18-1 und 18-2 bezeichnet, elektrisch mit den als schaltungsträgerseitige Bondbereiche dienenden Leiterbahnabschnitten 14-1 und 14-3 verbunden (kontaktiert) wurde.

Hierfür geeignete Drahtbondverfahren sind aus dem Stand der Technik hinreichend bekannt und bedürfen daher hier keiner eingehenden Erläuterung. Insbesondere können die Bonddrähte 18-1 und 18-2 mittels Thermokompressionsbonden, Thermosonic-Ball-Wedge-Bonden oder Ultraschall-Wedge-Wedge-Bonden an den Abschnitten 14-1 bzw. 14-2 kontaktiert werden. In jedem Fall entsteht eine Mikroverschweißung zwischen dem Drahtmaterial und dem betreffenden Leiterbahnmaterial zur Schaffung einer mechanischen und elektrischen Verbindung.

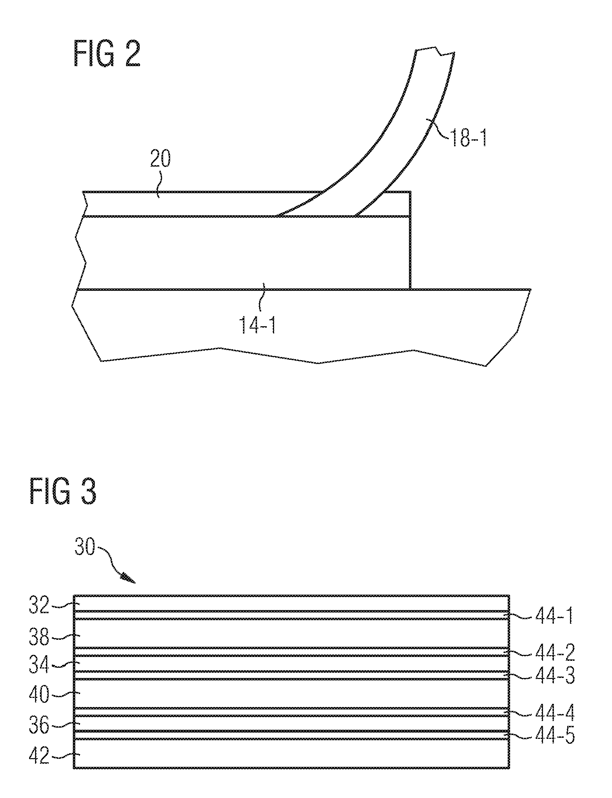

Eine vorteilhafte Besonderheit des dargestellten Schaltungsträgers 10 bzw. des anhand der Fig. 1A bis 1C dargestellten Anbindungsverfahrens ist aus der Detaildarstellung von Fig. 2 ersichtlich.

Fig. 2 zeigt die Fügestelle zwischen dem Bonddraht 18-1 und dem schaltungsträgerseitigen Bondbereich 14-1. An der Oberfläche des beispielsweise aus Kupfer gebildeten und als Bondbereich dienenden Leiterbahnabschnitts 14-1 ist eine vergleichsweise dünne Passivierungsschicht 20 ausgebildet, welche beim Bondprozess vom Material des Bonddrahts 18-1 durchdrungen wurde. Dasselbe gilt für die nicht detailliert dargestellte Fügestelle zwischen dem Bonddraht 18-2 und dem Leiterbahnabschnitt 14-3.

Die Passivierungsschicht 20 besitzt im dargestellten Ausführungsbeispiel eine einheitliche Dicke von etwa 10 µm und kann z. B. eine organische Passivierungsschicht ("OSP") darstellen, die bei der Herstellung des Schaltungsträgers 10 oder z. B. unmittelbar vor dem in Fig. 1 dargestellten Anbindungsprozess an allen betreffenden Bondbereichen ausgebildet wurde. Sie schützt die betreffenden Bondbereiche vor einer unkontrollierbaren Oberflächenveränderung, insbesondere Oxidation durch den Luftsauerstoff, so dass der Bondprozess mit erhöhter Zuverlässigkeit eine mechanisch stabile und elektrisch gut leitende Verbindung zwischen den Bonddrähten und den zugehörigen schaltungsträgerseitigen Bondbereichen schafft.

Für die Art und Weise der Ausbildung jeder Passivierungsschicht, wie der dargestellten Passivierungsschicht 20, kann vorteilhaft auf an sich bekannte Methoden zurückgegriffen werden. Insbesondere kann zur Ausbildung der Passivierungsschicht auf Methoden zurückgegriffen werden, wie sie an sich beim Herstellungsprozess einer mehrlagigen Leiterplatte üblicherweise im Stand der Technik bereits Anwendung finden. Geeignete, an sich bekannte Schichten sind lediglich beispielhaft in Fig. 3 dargestellt.

Fig. 3 zeigt schematisch den Aufbau (Laminat) einer mehrlagigen Leiterplatte 30 mit drei Leiterbahnlagen 32, 34 und 36 und drei Substratlagen 38, 40 und 42.

Am Übergang zwischen einer Leiterbahnlage und einer Substratlage ist jeweils eine Haftvermittlerschicht angeordnet. Diese Haftvermittlerschichten sind in Fig. 3 mit 44-1 bis 44-5 bezeichnet und sollen eine Delamination der Leiterplatte 30 verhindern. Derartige, aus dem Bereich der Leiterplattenherstellung an sich bekannte Zwischenschichten können vorteilhaft als Passivierungsschichten 20 im Rahmen des oben mit Bezug auf die Fig. 1 und 2 beschriebenen Anbindungsverfahrens Verwendung finden.

## Patentansprüche

1. Schaltungsträger für wenigstens ein mittels Bonddrähten (18-1, 18-2) daran anzubindendes Bauelement (BE), umfassend eine Leiterbahnanordnung (14) mit freiliegenden metallischen Bondbereichen (14-1, 14-2) zur schaltungsträgerseitigen Kontaktierung der Bonddrähte (18-1, 18-2),
**dadurch gekennzeichnet, dass** die Bondbereiche (14-1, 14-2) jeweils mit einer beim Bondprozess vom Drahtmaterial zu durchdringenden Passivierungsschicht (20) ausgebildet sind.

2. Schaltungsträger nach Anspruch 1, wobei die Passivierungsschicht (20) für deren Durchdringung bei einem Ultraschallschweißen des Drahtmaterials geeignet ausgebildet ist.

3. Schaltungsträger nach einem der vorangehenden Ansprüche, wobei die Passivierungsschicht (20) von einer Oxidschicht gebildet ist.

4. Schaltungsträger nach Anspruch 1 oder 2, wobei die Passivierungsschicht (20) von einer organischen Passivierungsschicht gebildet ist.

5. Schaltungsträger nach einem der vorangehenden Ansprüche, wobei als anzubindendes Bauelement (BE) ein ungehäustes Halbleiterbauelement vorgesehen ist.

6. Schaltungsanordnung, umfassend einen Schaltungsträger (10) nach einem der vorangehenden Ansprüche und wenigstens ein mittels Bonddrähten (18-1, 18-2) daran angebundenes Bauelement (BE), deren Drahtmaterial die jeweilige Passivierungsschicht (20) durchdringend an den Bondbereichen (14-1, 14-2) des Schaltungsträgers (10) kontaktiert ist.

7. Verfahren zur Herstellung eines Schaltungsträgers (10) für wenigstens ein mittels Bonddrähten (18-1, 18-2) daran anzubindendes Bauelement (BE), umfassend eine Leiterbahnanordnung (14) mit freiliegenden metallischen Bondbereichen (14-1, 14-2) zur schaltungsträgerseitigen Kontaktierung der Bonddrähte (18-1, 18-2),
**dadurch gekennzeichnet, dass** die Bondbereiche (14-1, 14-2) jeweils mit einer beim Bondprozess vom Drahtmaterial zu durchdringenden Passivierungsschicht (20) ausgebildet werden.

8. Verfahren zum Anbinden wenigstens eines Bauelements (BE) mittels Bonddrähten (18-1, 18-2) an freiliegenden metallischen Bondbereichen (14-1, 14-2) einer Leiterbahnanordnung (14) eines Schaltungsträgers (10),
**dadurch gekennzeichnet, dass** die Bondbereiche (14-1, 14-2) vor dem Bondprozess jeweils mit einer Passivierungsschicht (20) ausgebildet werden, welche beim Bondprozess vom jeweiligen Drahtmaterial durchdrungen wird.
